# EUROPEAN PATENT APPLICATION

(11) **EP 4 836 615 A1**
(43) Date of publication of application: **04.11.2026**
(21) Application number: 25205209.7
(22) Date of filing: 29.09.2025
(51) Int. Cl.: H05K 7/20

(54) **ELECTRONIC DEVICE AND COOLING SYSTEM**

(30) Priority: 30.04.2025 TW 114116262
(71) Applicant: Wistron Corporation, New Taipei City 22181 (TW)
(72) Inventor: CHENG, Liang Ching, 22181 New Taipei City (TW); WU, Yuchuan, 22181 New Taipei City (TW)
(74) Representative: Müller Schupfner & Partner Patent- und Rechtsanwaltspartnerschaft mbB (Muc)

(57) **Abstract**

An electronic device (10, 10C) is configured to accommodate a cooling fluid (L), and includes a chassis (20), a server (40, 40C), a heat sink (50, 50C) and a spray assembly (60, 60C). The chassis (20) is configured to accommodate the cooling fluid (L). The server (40, 40C) is disposed in the chassis (20). The server (40, 40C) includes a heat source (42). The heat sink (50, 50C) is connected to the heat source (42) of the server (40, 40C). The spray assembly (60, 60C) includes a fluid delivery component (61, 61A-61C). The fluid delivery component (61, 61A-61C) is disposed in the chassis (20), and includes a flow pipe (611A, 611B) and a nozzle (612A, 612B) connected to each other. The nozzle (612A, 612B) is configured to spray the cooling fluid (L) onto the heat sink (50, 50C).

## Description

### Technical Field

The present disclosure relates to an electronic device and a cooling system, more particularly to an electronic device and a cooling system having a heat sink and a spray assembly.

### Background

With the arrival of the big data era and the continuous development of cloud technology, the requirements for high performance servers are higher, and the amount of the data processed by the servers is increasing. Accordingly, the density of heat transferring at the servers rapidly increases, and heat generated thereby also increases massively. Therefore, the problem of heat dissipation needs to be solved urgently.

Conventionally, heat sources of servers are preferably cooled via two-phase cooling systems. Generally, the two-phase cooling systems are classified into an immersion cooling method and a direct fluid cooling method. The immersion cooling method refers to a method where the heat sources are completely immersed in a cooling fluid. The direct fluid cooling method refers to a method where the heat sources are in contact with a heat sink, and the cooling fluid is limited within closed pipelines without directly contacting with the heat sources during the cooling process.

However, the heat sources are required to be fully immersed in a large amount of cooling fluid via the immersion cooling method, thereby increasing the cost for using the cooling fluid of the cooling systems. Furthermore, bubbles may be generated from the cooling fluid, which absorbs the heat generated by the heat sources and evaporates, and sufficient space is required for the bubbles to rise, thereby performing a cooling circulation. Therefore, a density for placing the servers in a chassis having the cooling systems can be limited, thereby reducing a space utilization within the chassis. In addition, the cooling fluid evaporates within the closed pipelines via the direct fluid cooling method, which increases an internal pressure of the closed pipelines. Therefore, high-pressure-resistant pipelines are required to be adopted. However, a space within the chassis may be occupied by high-pressure-resistant pipelines, thereby causing an inconvenience for installing the servers and the cooling systems.

### SUMMARY

The present disclosure provides an electronic device and a cooling system so as to improve a cooling efficiency for cooling servers, reduce the cost of using the cooling fluid and the cost of installing the electronic device, and increase a space utilization within the electronic device.

One embodiment of the present disclosure provides an electronic device configured to accommodate a cooling fluid. The electronic device includes a chassis, at least one server, at least one heat sink and a spray assembly. The chassis is configured to accommodate the cooling fluid. The at least one server is disposed in the chassis. The at least one server includes at least one heat source. The at least one heat sink is connected to the at least one heat source of the at least one server. The spray assembly includes a fluid delivery component. The fluid delivery component is disposed in the chassis, and includes at least one flow pipe and at least one nozzle connected to each other. The at least one nozzle is configured to spray the cooling fluid onto the at least one heat sink.

Another embodiment of the present disclosure provides a cooling system configured to be disposed in a chassis that accommodates a cooling fluid and thermally coupled to at least one heat source. The cooling system includes at least one heat sink and a spray assembly. The at least one heat sink is configured to be thermally coupled to the at least one heat source. The spray assembly includes a fluid delivery component. The fluid delivery component is configured to be disposed in the chassis, and includes at least one flow pipe and at least one nozzle connected to each other. The at least one nozzle is configured to spray the cooling fluid onto the at least one heat sink.

According to the electronic device and the cooling system disclosed by the above embodiments, the appropriate cooling fluid is sprayed via the spray assembly. Accordingly, a liquid curtain can be formed on the heat sink when the spray assembly sprays the cooling fluid onto the heat sink, thereby continuously performing the thin film evaporation on the heat sink to improve the cooling efficiency.

### BRIEF DESCRIPTION OF THE DRAWINGS

The present disclosure will become more fully understood from the detailed description given herein below and the accompanying drawings, which are given by way of illustration only and thus are not limitative of the present disclosure and wherein:
FIG. 1 is a side view of an electronic device in accordance with a first embodiment of the present disclosure;
FIG. 2 is another side view of the electronic device in FIG. 1;
FIG. 3 is a partially enlarged view of the electronic device in FIG. 2;
FIG. 4 is a side view of a heat sink and a fluid delivery component of the electronic device in FIG. 1;
FIG. 5 is a perspective view of the fluid delivery component of the electronic device in FIG. 1;
FIG. 6 is a perspective view of a fluid delivery component in accordance with a second embodiment of the present disclosure;
FIG. 7 is a perspective view of a fluid delivery component in accordance with a third embodiment of the present disclosure; and
FIG. 8 is a side view of an electronic device in accordance with a fourth embodiment of the present disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In addition, the terms used in the present disclosure, such as technical and scientific terms, have its own meanings and can be comprehended by those skilled in the art, unless the terms are additionally defined in the present disclosure. That is, the terms used in the following paragraphs should be read on the meaning commonly used in the related fields and will not be overly explained, unless the terms have a specific meaning in the present disclosure.

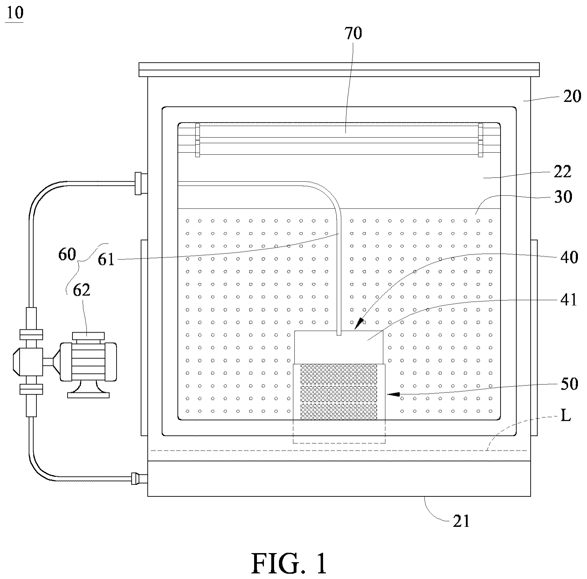

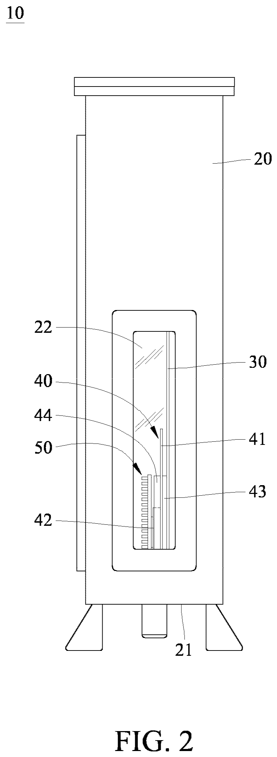

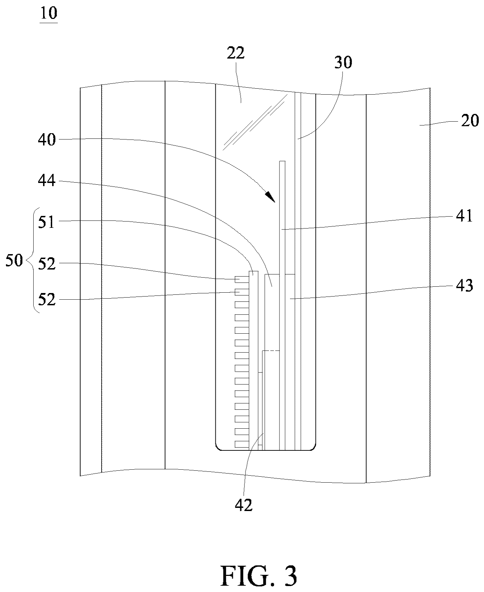

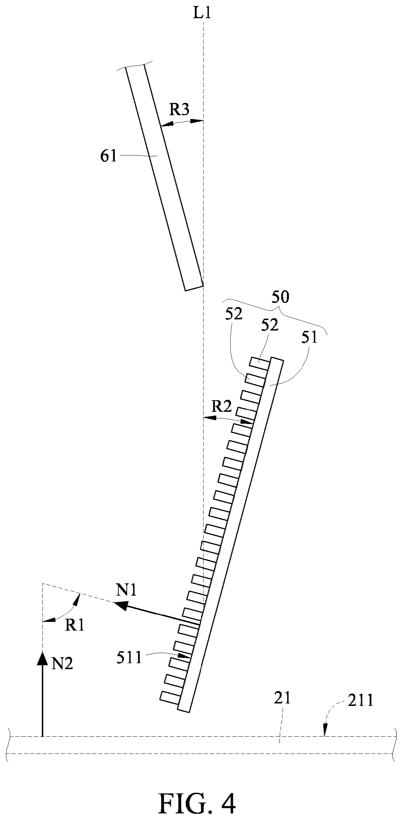

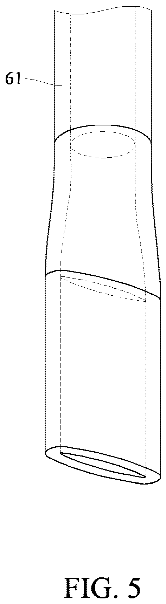

Please refer to FIG. 1 to FIG. 5, where FIG. 1 is a side view of an electronic device 10 in accordance with a first embodiment of the present disclosure, FIG. 2 is another side view of the electronic device 10 in FIG. 1, FIG. 3 is a partially enlarged view of the electronic device 10 in FIG. 2, FIG. 4 is a side view of a heat sink 50 and a fluid delivery component 61 of the electronic device 10 in FIG. 1, and FIG. 5 is a perspective view of the fluid delivery component 61 of the electronic device 10 in FIG. 1.

In this embodiment, the electronic device 10 is applied to, for example, a two-phase cooling system, and is configured to accommodate a cooling fluid L. The cooling fluid L is, for example, a fluorinated coolant, but the present disclosure is not limit thereto. The electronic device 10 includes a chassis 20, a mounting frame 30, a server 40, a heat sink 50 and a spray assembly 60. The chassis 20 is configured to accommodate the cooling fluid L, and includes a bottom plate 21. The mounting frame 30 is disposed in the chassis 20.

The server 40 is disposed in the chassis 20, and is mounted on the mounting frame 30. In detail, the server 40 includes a circuit board 41, a heat source 42, a first fixing frame 43 and a second fixing frame 44. The heat source 42 is, for example, a GPU chip, but the present disclosure is not limit thereto. The heat source 42 is disposed on the circuit board 41. The first fixing frame 43 is disposed on the mounting frame 30. At least a part of the circuit board 41 is clamped by the first fixing frame 43 and the second fixing frame 44. The second fixing frame 44 surrounds the heat source 42.

In this embodiment, the server 40 is located above a fluid level of the cooling fluid L without being immersed therein. Accordingly, for example, the amount of the cooling fluid L used can be reduced by 80%, thereby reducing the cost of using the cooling fluid L by 80%.

The heat sink 50 is connected to the heat source 42, and is fixed to the second fixing frame 44. In detail, the heat sink 50 includes a base 51 and a plurality of cooling protrusions 52. The base 51 is connected to the heat source 42, and is fixed to the second fixing frame 44. The cooling protrusions 52 protrude from a side of the base 51 away from the heat source 42. An angle R1 is formed between a normal vector N1 of a surface 511 of the base 51 facing away from the heat source 42 and a normal vector N2 of a surface 211 of the bottom plate 21 facing the heat sink 50. For example, the angle R1 is greater than 0 degrees and less than 90 degrees. That is, the heat sink 50 is, for example, not parallel to the bottom plate 21. In detail, the base 51 of the heat sink 50 is not parallel to the bottom plate 21. That is, the base 51 is not horizontally disposed in the chassis 20.

The spray assembly 60 includes a fluid delivery component 61 and a fluid driving component 62 in fluid communication with each other. The fluid delivery component 61 is, for example, a flow pipe. The fluid delivery component 61 is disposed in the chassis 20. An end of the fluid delivery component 61 is configured to spray the cooling fluid L onto the heat sink 50. A liquid curtain can be formed on the heat sink 50 to perform a thin film evaporation via capillarity, gravity, and a surface tension of the cooling fluid L during a process of the fluid delivery component 61 spraying the cooling fluid L onto the heat sink 50. In addition, after the cooling fluid L in a liquid state undergoes thin film evaporation and transforms into a gaseous state, the cooling fluid L can directly leave the liquid curtain without disturbing the flow of the liquid cooling fluid L. Moreover, the end of the fluid delivery component 61 configured to spray the cooling fluid L is, for example, flat. Accordingly, the cooling fluid L can be sprayed more evenly onto the heat sink 50, thereby performing highly efficient thin film evaporation.

The fluid driving component 62 is connected to the chassis 20, and is configured to drive the cooling fluid L to flow to the fluid delivery component 61. Accordingly, the fluid delivery component 61 can spray the cooling fluid L onto the heat sink 50. The fluid driving component 62 is located outside the chassis 20, and is, for example, a mechanical pump. In addition, a flow rate of the fluid driving component 62 can be adjusted via program control. In detail, a voltage and a current of the fluid driving component 62 can be controlled via pulse width modulation (PWM), such that the flow rate of the fluid driving component 62 can be adjusted according to a temperature of the heat source 42. Accordingly, the liquid curtain of the cooling fluid L can be maintained to be formed on the surface of the heat sink 50, thereby continuously performing highly efficient thin film evaporation.

In this embodiment, an angle R2 between the base 51 and a vertical line L1 whose extending direction is parallel to a direction of gravity is, for example, greater than or equal to 0 degrees and less than or equal to 30 degrees. In detail, the angle R2 between a straight line perpendicular to a normal vector of the surface 511 of the base 51 facing away from the heat source 42 and the vertical line L1 whose extending direction is parallel to the direction of gravity is, for example, greater than or equal to 0 degrees and less than or equal to 30 degrees. For example, the angle R2 between the base 51 and the vertical line L1 is 15 degrees. Accordingly, the liquid curtain is facilitated to be formed on the heat sink 50 by the cooling fluid L.

In addition, an angle R3 between the vertical line L1 and a direction along which the fluid delivery component 61 sprays the cooling fluid L onto the heat sink 50 is greater than or equal to 0 degrees and less than or equal to 30 degrees. For example, the angle R3 between the vertical line L1 and the direction along which the fluid delivery component 61 sprays the cooling fluid L onto the heat sink 50 is 15 degrees. Accordingly, the liquid curtain is facilitated to be formed on the heat sink 50 by the cooling fluid L.

Moreover, an accumulated rate of the cooling fluid is, for example, less than or equal to 3 millimeters per second. That is, the rate configured for the cooling fluid L to be accumulated on per unit surface area of the base 51 is, for example, less than or equal to 3 millimeters per second. The concept of the accumulation of the cooling fluid L can be understood by the concept of rainfall accumulation. That is, a height of the cooling fluid L accumulated per second on each unit surface area of the base 51 is, for example, less than or equal to 3 millimeters. For example, when the flow rate of the fluid driving component 62 is 6 liters per minute (L/min) and a surface area of the heat sink 50 is 757.2 square centimeters (cm²), an accumulation rate of the cooling fluid L would be 1.3 millimeters per second (mm/s). Accordingly, the accumulation of the cooling fluid L on the surface of the base 51 can be prevented from occurring too quickly, preventing flooding of the surface of the base 51, thereby facilitating the formation of the liquid curtain of the cooling fluid L on the heat sink 50 by the cooling fluid L. The flow rate of the fluid driving component 62 is, for example, equal to a flow rate of the cooling fluid L sprayed from the end of the fluid delivery component 61.

In this embodiment, the electronic device 10 may include a condenser 70. The heat sink 50, the spray assembly 60 and the condenser 70 together form a cooling system. The condenser 70 is disposed in the chassis 20. The server 40 and the heat sink 50 are located between the bottom plate 21 and the condenser 70. When the liquid cooling fluid L is sprayed from the end of the fluid delivery component 61 onto the heat sink 50, the cooling fluid L can evaporate into a gaseous state. Then, the condenser 70 is configured to condense the cooling fluid L from gas back into liquid, such that the cooling fluid L in a liquid state drips back to the bottom of the chassis 20 to perform a cooling circulation. Therefore, not only can the usage of the cooling fluid L be further reduced, but the internal pressure inside the chassis 20 can also be lowered via the condensation of the cooling fluid L inside the chassis 20 without the need of high-pressure-resistant pipelines. Accordingly, an installation cost for maintaining an airtightness of the chassis 20 can be reduced and an operational safety can be improved.

In this embodiment, different sides of the chassis 20 may include a plurality of transparent windows 22. The transparent windows 22 are, for example, glass windows. An inner space of the chassis 20 is visible from outside via the transparent windows 22, such that an internal condition of the chassis 20 can be monitored. In FIG. 1, the components within the internal space of the chassis 20, which are visible via the transparent windows 22, are illustrated with fine lines.

In this embodiment, the electronic device 10 may include a collector (not shown). The collector is disposed between the server 40 and the condenser 70. After the condenser 70 condenses the cooling fluid from gas into liquid, the cooling fluid L in the liquid state drips back to the collector. Then, the cooling fluid L collected by the collector can be, for example, sprayed onto the heat sink 50 by the spray assembly 60. That is, the collector and the spray assembly 60 can be configured to together spray the cooling fluid L onto the heat sink 50. Accordingly, the cooling efficiency can be further improved.

In this embodiment, the heat sink 50 is not parallel to the bottom plate 21, and the appropriate cooling fluid L is sprayed via the spray assembly 60. Accordingly, the liquid curtain can be formed on the heat sink 50 when the spray assembly 60 sprays the cooling fluid L onto the heat sink 50, thereby continuously performing the thin film evaporation on the heat sink 50 to improve the cooling efficiency.

For example, when a heat generation of the heat source 42 is 400 watts (W), a conventional immersion cooling system may cool the heat source 42 to 63.1 °C, whereas the cooling system of this embodiment may further cool the heat source 42 to 57.1 °C. When the heat generation of the heat source 42 is 800 watts, the conventional immersion cooling system may cool the heat source 42 to 72.0 °C, whereas the cooling system of this embodiment may further cool the heat source 42 to 64.4 °C. When the heat generation of the heat source 42 is 1200 watts, the conventional immersion cooling system may cool the heat source 42 to 79.2 °C, whereas the cooling system of this embodiment may further cool the heat source 42 to 72.6 °C.

In addition, for example, when a heat generation of the heat source 42 is 400 watts, a temperature difference between the heat source 42 and an external environment can be 14.1 °C after the immersion cooling system cools the heat source 42, whereas a temperature difference between the heat source 42 and the external environment can be further lowered to 8.1 °C after the cooling system of this embodiment cools the heat source 42. That is, a cooling performance of the cooling system of this embodiment can be improved, for example, by 42.7%. When the heat generation of the heat source 42 is 800 watts, the temperature difference between the heat source 42 and the external environment can be 23.0 °C after the immersion cooling system cools the heat source 42, whereas the temperature difference between the heat source 42 and the external environment can be further lowered to 15.4 °C after the cooling system of this embodiment cools the heat source 42. That is, the cooling performance of the cooling system of this embodiment can be improved, for example, by 32.9%. When the heat generation of the heat source 42 is 1200 watts, the temperature difference between the heat source 42 and the external environment can be 30.2 °C after the immersion cooling system cools the heat source 42, whereas the temperature difference between the heat source 42 and the external environment can be further lowered to 23.6 °C after the cooling system of this embodiment cools the heat source 42. That is, the cooling performance of the cooling system of this embodiment can be improved, for example, by 22.0%.

In addition, the spray assembly 60 sprays the cooling fluid L onto the heat sink 50 to cool the heat source 42 without a large amount of the cooling liquid to fully immerse the server 40. An internal pressure inside the chassis 20 can be reduced via the condenser 70 without the need of high-pressure-resistant pipelines to maintain an airtightness of the chassis 20. Therefore, the usage of the cooling fluid L and the installation cost of the electronic device 10 can be reduced.

Moreover, after the cooling fluid L evaporates into a gaseous state on the heat sink 50, the cooling fluid L in the gaseous state can directly leave the liquid curtain without forming bubbles. Therefore, the cooling circulation of the cooling fluid L can be performed without an additional space for the bubbles to escape. Accordingly, the inner space of the chassis 20 can be more available to improve a flexibility for the server 40 to be disposed in the chassis 20, thereby increasing a space utilization within the chassis 20.

In this embodiment, the electronic device 10 includes the mounting frame 30, and the server 40 is mounted on the mounting frame 30, but the present disclosure is not limit thereto. In another embodiment, the electronic device may not include the mounting frame, but may include other types of fixtures, such as clamps, for mounting the server.

In this embodiment, the server 40 is located above the fluid level of the cooling fluid L, but the present disclosure is not limit thereto. In another embodiment, at least a part of the server may be located below the fluid level of the cooling fluid. That is, a part of the server located above the fluid level of the cooling fluid is cooled by the spray assembly of this embodiment, while the other part of the server located below the fluid level of the cooling fluid is cooled via an immersion cooling manner.

In this embodiment, the fluid driving component 62 is located outside the chassis 20, but the present disclosure is not limit thereto. In another embodiment, the fluid driving component may be located in the chassis.

In this embodiment, there is one fluid driving component 62, but the present disclosure is not limit thereto. In another embodiment, there may be multiple the fluid driving components.

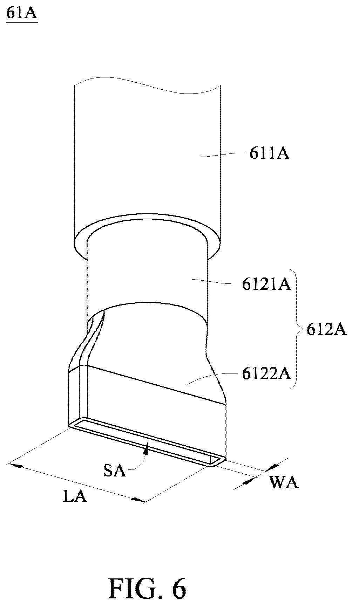

Please refer to FIG. 6, which is a perspective view of a fluid delivery component 61A in accordance with a second embodiment of the present disclosure. In this embodiment, the fluid delivery component 61A includes a flow pipe 611A and a nozzle 612A. An end of the flow pipe 611A is connected to the fluid driving component 62. Another end of the flow pipe 611A is connected to the nozzle 612A.

In detail, the nozzle 612A includes a connecting portion 6121A and a spray portion 6122A in fluid communication with each other. The connecting portion 6121A is connected to the flow pipe 611A. The spray portion 6122A is, for example, flat. That is, a cross section of the spray portion 6122A is, for example, strip-shaped. Furthermore, the spray portion 6122A has a spray outlet SA. The spray outlet SA is, for example, flat. Therefore, the aforementioned cooling fluid L can be sprayed, for example, as a fan-shaped liquid film onto the aforementioned heat sink 50 via the nozzle 612A. Accordingly, the cooling fluid L can be sprayed more evenly onto the heat sink 50, thereby performing highly efficient thin film evaporation. A length LA of the spray outlet SA is, for example, 29 millimeters. A width WA of the spray outlet SA is, for example, 3 millimeters.

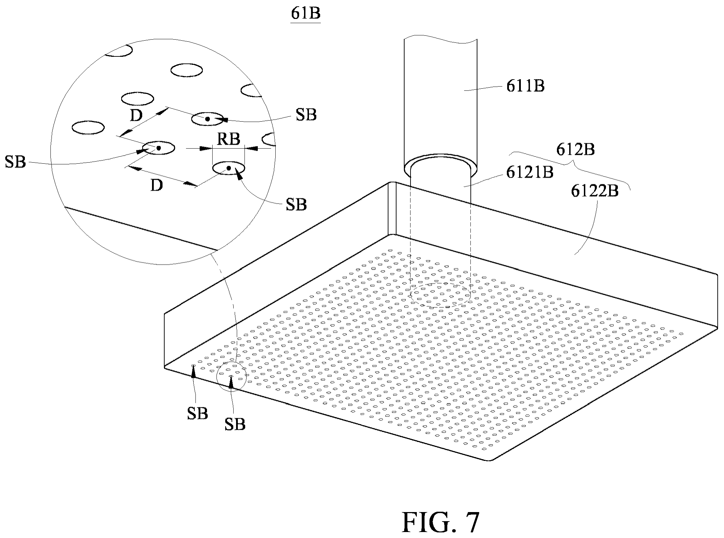

Please refer to FIG. 7, which is a perspective view of a fluid delivery component 61B in accordance with a third embodiment of the present disclosure. The fluid delivery component 61B of this embodiment is similar to the fluid delivery component 61A of the second embodiment, and the main differences between them will be described below. The same parts between them can be referred to in the aforementioned paragraphs with the reference to FIG. 6, and will not be repeatedly introduced hereinafter. In this embodiment, the spray portion 6122B has a plurality of spray outlets SB. The spray outlets SB are, for example, arranged in an array. Therefore, the aforementioned cooling fluid L can be split into a plurality of tiny liquid columns via the nozzle 612B, and the tiny liquid columns are sprayed onto the aforementioned heat sink 50. Accordingly, the cooling fluid L can be sprayed more evenly onto the heat sink 50, thereby performing highly efficient thin film evaporation. A diameter RB of each of the spray outlets SB is, for example, 1.5 millimeters. A distance D between centers of any two adjacent spray outlets SB is, for example, 4 millimeters.

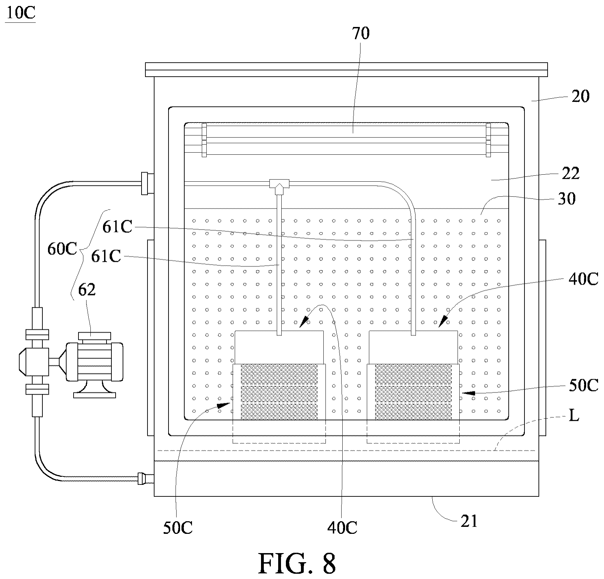

In the first embodiment, there is merely one server 40, one heat sink 50 and one fluid delivery component 61, but the present disclosure is not limit thereto. In another embodiment, please refer to FIG. 8, which is a side view of an electronic device 10C in accordance with a fourth embodiment of the present disclosure. The electronic device 10C of this embodiment is similar to the electronic device 10 of the first embodiment, and the main differences between them will be described below. The same parts between them can be referred to the aforementioned paragraphs with the reference to FIG. 1 to FIG. 5, and will not be repeatedly introduced hereinafter.

In this embodiment, there may be multiple servers 40C, multiple heat sinks 50C and multiple fluid delivery components 61C of the spray assembly 60C. In detail, since the cooling fluid L evaporates into the gaseous state on the heat sink 50C and can directly leave the liquid curtain, a minimal space is required merely to allow the cooling fluid L to perform the cooling cycle. Therefore, there can be more than one server 40C disposed in the chassis 20 to be cooled. Accordingly, the space utilization within the chassis 20 can be increased.

According to the electronic device and the cooling system disclosed by the above embodiments, the heat sink is not parallel to the bottom plate. Accordingly, the liquid curtain can be formed on the heat sink when the spray assembly sprays the cooling fluid onto the heat sink, thereby continuously performing the thin film evaporation on the heat sink to improve the cooling efficiency.

In addition, the spray assembly sprays the cooling fluid onto the heat sink to cool the heat source without a large amount of the cooling liquid to fully immerse the server. An internal pressure inside the chassis can be reduced via the condenser without the need of high-pressure-resistant pipelines to maintain an airtightness of the chassis. Therefore, the usage of the cooling fluid and the installation cost of the electronic device can be reduced.

Moreover, after the cooling fluid evaporates into the gaseous state on the heat sink, the cooling fluid in the gaseous state can directly leave the liquid curtain without forming bubbles. Therefore, the cooling circulation of the cooling fluid can be performed without additional space for the bubbles to escape. Accordingly, the inner space of the chassis can be more available to improve a flexibility for the server to be disposed in the chassis, thereby increasing a space utilization within the chassis.

It will be apparent to those skilled in the art that various modifications and variations can be made to the present disclosure. It is intended that the specification and examples be considered as exemplary embodiments only, with the scope of the present disclosure being indicated by the following claims.

## Claims

1. An electronic device (10, 10C) configured to accommodate a cooling fluid (L), the electronic device comprising:
a chassis (20) configured to accommodate the cooling fluid (L);
at least one server (40, 40C) disposed in the chassis (20), wherein the at least one server (40, 40C) comprises at least one heat source (42);
at least one heat sink (50, 50C) connected to the at least one heat source (42) of the at least one server (40, 40C); and
a spray assembly (60, 60C) comprising a fluid delivery component (61, 61A-61C), wherein the fluid delivery component (61, 61A-61C) is disposed in the chassis (20), and comprises at least one flow pipe (611A, 611B) and at least one nozzle (612A, 612B) connected to each other, and the at least one nozzle (612A, 612B) is configured to spray the cooling fluid (L) onto the at least one heat sink (50, 50C).

2. The electronic device according to claim 1, wherein the spray assembly (60, 60C) further comprises a fluid driving component (62), the fluid driving component (62) is configured to be connected to the chassis (20), and is configured to drive the cooling fluid (L) to flow to the fluid delivery component (61, 61A-61C).

3. The electronic device according to claim 1, wherein the at least one nozzle (612A) comprises a connecting portion (6121A) and a spray portion (6122A) in fluid communication with each other, the connecting portion (6121A) is connected to the at least one flow pipe (611A), and the spray portion (6122A) is flat.

4. The electronic device according to claim 1, wherein the at least one nozzle (612B) comprises a connecting portion (6121B) and a spray portion (6122B) in fluid communication with each other, the connecting portion (6121B) is connected to the at least one flow pipe (611B), and the spray portion (6122B) has a plurality of spray outlets (SB).

5. The electronic device according to claim 1, wherein an angle (R3) between a direction along which the at least one nozzle (612A, 612B) sprays the cooling fluid (L) onto the at least one heat sink (50, 50C) and a vertical line (L1) is greater than or equal to 0 degrees and less than or equal to 30 degrees.

6. The electronic device according to claim 1, further comprising at least one mounting frame (30), wherein the at least one mounting frame (30) is disposed in the chassis (20), the at least one server (20) further comprises a circuit board (41), a first fixing frame (43) and a second fixing frame (44), the at least one heat source (42) is disposed on the circuit board (41), the first fixing frame (43) is disposed on the at least one mounting frame (30), at least a part of the circuit board (41) is located between the first fixing frame (43) and the second fixing frame (44), the second fixing frame (44) surrounds the at least one heat source (42), and the at least one heat sink (50, 50C) is fixed to the second fixing frame (44).

7. The electronic device according to claim 1, wherein the chassis (20) comprises a bottom plate (21), an angle (R1) is formed between a normal vector (N1) of a surface (511) of the at least one heat sink (50, 50C) facing away from the at least one heat source (42) and a normal vector (N2) of a surface (211) of the bottom plate (21) facing the at least one heat sink (50, 50C), and the angle (R1) is greater than 0 degrees and less than 90 degrees.

8. The electronic device according to claim 7, further comprising a condenser (70), wherein the condenser (70) is disposed in the chassis (20), and the at least one server (40, 40C) and the at least one heat sink (50, 50C) are located between the bottom plate (21) and the condenser (70).

9. The electronic device according to claim 1, wherein the at least one heat sink (50, 50C) comprises a base (51) and a plurality of cooling protrusions (52), the base (51) is configured to be connected to the at least one heat source (42), the plurality of cooling protrusions (52) protrude from a side of the base (51) away from the at least one heat source (42), and an angle (R2) between the base (51) and a vertical line (L1) is greater than or equal to 0 degrees and less than or equal to 30 degrees.

10. A cooling system, configured to be disposed in a chassis (20) that accommodates a cooling fluid (L), the cooling system comprising:
at least one heat sink (50, 50C) configured to be thermally coupled to at least one heat source (42); and
a spray assembly (60, 60C) comprising a fluid delivery component (61, 61A-61C), wherein the fluid delivery component (61, 61A-61C) is configured to be disposed in the chassis (20), and comprises at least one flow pipe (611A, 611B) and at least one nozzle (612A, 612B) connected to each other, and the at least one nozzle (612A, 612B) is configured to spray the cooling fluid (L) onto the at least one heat sink (50, 50C).

11. The cooling system according to claim 10, wherein the spray assembly (60, 60C) further comprises a fluid driving component (62), the fluid driving component (62) is configured to be connected to the chassis (20), and is configured to drive the cooling fluid (L) to flow to the fluid delivery component (61, 61A-61C).

12. The cooling system according to claim 10, wherein the at least one nozzle (612A) comprises a connecting portion (6121A) and a spray portion (6122A) in fluid communication with each other, the connecting portion (6121A) is connected to the at least one flow pipe (611A), and the spray portion (6122A) is flat.

13. The cooling system according to claim 10, wherein the at least one nozzle (612B) comprises a connecting portion (6121B) and a spray portion (6122B) in fluid communication with each other, the connecting portion (6121B) is connected to the at least one flow pipe (611B), and the spray portion (6122B) has a plurality of spray outlets (SB).

14. The cooling system according to claim 10, wherein an angle (R1) is formed between a normal vector (N1) of a surface (511) of the at least one heat sink (50, 50C) facing away from the at least one heat source (42) and a normal vector (N2) of a surface (211) of a bottom plate (21) of the chassis (20) facing the at least one heat sink (50, 50C), and the angle (R1) is greater than 0 degrees and less than 90 degrees.

15. The cooling system according to claim 10, wherein the at least one heat sink (50, 50C) comprises a base (51) and a plurality of cooling protrusions (52), the base (51) is configured to be connected to the at least one heat source (42), the plurality of cooling protrusions (52) protrude from a side of the base (51) away from the at least one heat source (42), and an angle (R2) between the base (51) and a vertical line (L1) is greater than or equal to 0 degrees and less than or equal to 30 degrees.

## Amended claims

### Amended claims in accordance with Rule 137(2) EPC.

1. An electronic device (10, 10C) configured to accommodate a cooling fluid (L), the electronic device comprising:
a chassis (20) configured to accommodate the cooling fluid (L); and
at least one server (40, 40C) disposed in the chassis (20), wherein the at least one server (40, 40C) is configured to be located above a fluid level of the cooling fluid (L) without being immersed therein, and comprises at least one heat source (42);
**characterized by**
at least one heat sink (50, 50C) connected to the at least one heat source (42) of the at least one server (40, 40C); and
a spray assembly (60, 60C) comprising a fluid delivery component (61, 61A-61C), wherein the fluid delivery component (61, 61A-61C) is disposed in the chassis (20), and comprises at least one flow pipe (611A, 611B) and at least one nozzle (612A, 612B) connected to each other, and the at least one nozzle (612A, 612B) is configured to spray the cooling fluid (L) onto the at least one heat sink (50, 50C).

2. The electronic device according to claim 1, wherein the spray assembly (60, 60C) further comprises a fluid driving component (62), the fluid driving component (62) is configured to be connected to the chassis (20), and is configured to drive the cooling fluid (L) to flow to the fluid delivery component (61, 61A-61C).

3. The electronic device according to claim 1, wherein the at least one nozzle (612A) comprises a connecting portion (6121A) and a spray portion (6122A) in fluid communication with each other, the connecting portion (6121A) is connected to the at least one flow pipe (611A), and the spray portion (6122A) is flat.

4. The electronic device according to claim 1, wherein the at least one nozzle (612B) comprises a connecting portion (6121B) and a spray portion (6122B) in fluid communication with each other, the connecting portion (6121B) is connected to the at least one flow pipe (611B), and the spray portion (6122B) has a plurality of spray outlets (SB).

5. The electronic device according to claim 1, wherein an angle (R3) between a direction along which the at least one nozzle (612A, 612B) sprays the cooling fluid (L) onto the at least one heat sink (50, 50C) and a vertical line (L1) whose extending direction is parallel to the direction of gravity is greater than or equal to 0 degrees and less than or equal to 30 degrees.

6. The electronic device according to claim 1, further comprising at least one mounting frame (30), wherein the at least one mounting frame (30) is disposed in the chassis (20), the at least one server (20) further comprises a circuit board (41), a first fixing frame (43) and a second fixing frame (44), the at least one heat source (42) is disposed on the circuit board (41), the first fixing frame (43) is disposed on the at least one mounting frame (30), at least a part of the circuit board (41) is located between the first fixing frame (43) and the second fixing frame (44), the second fixing frame (44) surrounds the at least one heat source (42), and the at least one heat sink (50, 50C) is fixed to the second fixing frame (44).

7. The electronic device according to claim 1, wherein the chassis (20) comprises a bottom plate (21), an angle (R1) is formed between a normal vector (N1) of a surface (511) of the at least one heat sink (50, 50C) facing away from the at least one heat source (42) and a normal vector (N2) of a surface (211) of the bottom plate (21) facing the at least one heat sink (50, 50C), and the angle (R1) is greater than 0 degrees and less than 90 degrees.

8. The electronic device according to claim 7, further comprising a condenser (70), wherein the condenser (70) is disposed in the chassis (20), and the at least one server (40, 40C) and the at least one heat sink (50, 50C) are located between the bottom plate (21) and the condenser (70).

9. The electronic device according to claim 1, wherein the at least one heat sink (50, 50C) comprises a base (51) and a plurality of cooling protrusions (52), the base (51) is configured to be connected to the at least one heat source (42), the plurality of cooling protrusions (52) protrude from a side of the base (51) away from the at least one heat source (42), and an angle (R2) between the base (51) and a vertical line (L1) whose extending direction is parallel to the direction of gravity is greater than or equal to 0 degrees and less than or equal to 30 degrees.

10. A cooling system, configured to be disposed in a chassis (20) that accommodates a cooling fluid (L) and thermally coupled to at least one heat source (42) of at least one server (40, 40C), the cooling system being **characterized by**:
at least one heat sink (50, 50C) configured to be thermally coupled to the at least one heat source (42) of the at least one server (40, 40C), wherein the at least one heat sink (50, 50C) and the at least one server (40, 40C) is configured to be located above a fluid level of the cooling fluid (L) without being immersed therein;
a spray assembly (60, 60C) comprising a fluid delivery component (61, 61A-61C), wherein the fluid delivery component (61, 61A-61C) is configured to be disposed in the chassis (20), and comprises at least one flow pipe (611A, 611B) and at least one nozzle (612A, 612B) connected to each other, and the at least one nozzle (612A, 612B) is configured to spray the cooling fluid (L) onto the at least one heat sink (50, 50C); and
a condenser (70) disposed in the chassis (20), and the at least one heat sink (50, 50C) and the at least one server (40, 40C) are configured to be located between a bottom plate (21) of the chassis (20) and the condenser (70).

11. The cooling system according to claim 10, wherein the spray assembly (60, 60C) further comprises a fluid driving component (62), the fluid driving component (62) is configured to be connected to the chassis (20), and is configured to drive the cooling fluid (L) to flow to the fluid delivery component (61, 61A-61C).

12. The cooling system according to claim 10, wherein the at least one nozzle (612A) comprises a connecting portion (6121A) and a spray portion (6122A) in fluid communication with each other, the connecting portion (6121A) is connected to the at least one flow pipe (611A), and the spray portion (6122A) is flat.

13. The cooling system according to claim 10, wherein the at least one nozzle (612B) comprises a connecting portion (6121B) and a spray portion (6122B) in fluid communication with each other, the connecting portion (6121B) is connected to the at least one flow pipe (611B), and the spray portion (6122B) has a plurality of spray outlets (SB).

14. The cooling system according to claim 10, wherein an angle (R1) is formed between a normal vector (N1) of a surface (511) of the at least one heat sink (50, 50C) facing away from the at least one heat source (42) and a normal vector (N2) of a surface (211) of a bottom plate (21) of the chassis (20) facing the at least one heat sink (50, 50C), and the angle (R1) is greater than 0 degrees and less than 90 degrees.

15. The cooling system according to claim 10, wherein the at least one heat sink (50, 50C) comprises a base (51) and a plurality of cooling protrusions (52), the base (51) is configured to be connected to the at least one heat source (42), the plurality of cooling protrusions (52) protrude from a side of the base (51) away from the at least one heat source (42), and an angle (R2) between the base (51) and a vertical line (L1) whose extending direction is parallel to the direction of gravity is greater than or equal to 0 degrees and less than or equal to 30 degrees.
